# EUROPEAN PATENT APPLICATION

(11) **EP 4 801 208 A1**
(43) Date of publication of application: **02.09.2026**
(21) Application number: 24884534.9
(22) Date of filing: 23.10.2024
(51) Int. Cl.: H05K 7/06

(54) **FLEXIBLE MOUNTING FRAME SYSTEM USING CIRCUIT BOARD TO PROVIDE CIRCUIT CONNECTIVITY**

(30) Priority: 30.10.2023 CN 202322929540 U
(71) Applicant: Cao, Zhiwei, Shanghai 201210 (CN)
(72) Inventor: Cao, Zhiwei, Shanghai 201210 (CN)
(74) Representative: Canzler & Bergmeier Patentanwälte Partnerschaft mbB
(86) International application number: PCT/CN2024/126649
(87) International publication number: WO 2025/092530

(57) **Abstract**

The present invention relates to a flexible mounting frame system using a circuit board to provide circuit connectivity. The flexible mounting frame system comprises a supporting plate; a plurality of mounting stations are provided on a supporting front surface of the supporting plate; and supporting-side connection structures capable of being detachably connected to device-side connection structures of electrical devices are provided at the mounting stations. Each electrical device is provided with a first contact electrical connection structure. The flexible mounting frame system further comprises a wiring circuit board; the wiring circuit board is arranged on a supporting back surface of the supporting plate; a plurality of power connection units are arranged on the wiring circuit board; each power connection unit comprises a second contact electrical connection structure and a circuit connected to the second contact electrical connection structure; power connection through holes are formed in the supporting plate; and the second contact electrical connection structures are aligned with the power connection through holes. When the electrical device is mounted at the mounting station, the device-side connection structure is connected to the supporting-side connection structure, and the first contact electrical connection structure and the second contact electrical connection structure are kept in contact and connected via the power connection through hole.

## Description

### FIELD OF THE INVENTION

The present invention relates to the technical field of equipment mounting and support structures, and in particular to a flexible mounting rack system with a circuit board for electrical connection.

### BACKGROUND OF THE INVENTION

In places such as exhibition halls, shopping malls, supermarkets, and general stores, various objects often need to be mounted on corresponding mounting racks for placement or display. Because the objects are often removed and repositioned, the mounting method on the mounting racks must be flexible and convenient. At the same time, for many electrically powered devices (hereinafter referred to as "electrical devices"), a convenient electrical connection also needs to be considered when the electrical devices are mounted on the mounting racks. Although many conventional mounting racks allow flexible installation and removal of electrical devices, they do not satisfactorily address electrical connection issues. A common approach is to supply power through external wires, which is inconvenient. For example, Chinese Utility Model Patent Application No. CN202223357889.8 discloses a simple rotating display stand. In order to allow height adjustment of the rotating display stand, a lifting support plate is provided as a mounting rack, and multiple connection holes at different heights are formed in the lifting support plate for connecting electrical devices. One of the electrical devices includes a support bracket, a support wheel assembly, a display board, and a rotation driving mechanism. The support bracket is mounted in the connection holes at different heights through a connecting portion, thereby allowing the display board to be adjusted to different heights. In addition, multiple electrical devices may also be mounted in the connection holes at different heights, thereby facilitating installation of the electrical devices on the lifting support plate. However, the above design still has the following drawbacks. Since the electrical devices require a power supply, electrical wires need to be led out from the electrical devices and routed along the lifting support plate. When the mounting height of an electrical device needs to be adjusted, the corresponding wires also need to be moved accordingly, resulting in cumbersome operation. In addition, when multiple display board devices are mounted on the lifting support plate, the number of wires increases accordingly, which easily leads to cluttered wiring and poor overall neatness, thereby not only making wiring inconvenient but also adversely affecting overall appearance.

### SUMMARY OF THE INVENTION

The present invention provides a flexible mounting rack system with a circuit board for electrical connection, which facilitates mounting, removal, and positional adjustment of an electrical device on a support plate by reducing the complexity of electrical connection during installation, while also improving overall neatness and appearance.

The present invention provides a flexible mounting rack system with a circuit board for providing electrical connection, configured to accommodate an electrical device requiring power supply. The electrical device includes a device-side connection structure. The flexible mounting rack system includes a support plate, and opposite side surfaces of the support plate are respectively defined as a support front surface and a support rear surface. The electrical device is mounted on the support front surface. The support front surface is provided with a plurality of mounting stations for mounting the electrical device, and each of the mounting stations is provided with a support-side connection structure configured to detachably connect with the device-side connection structure. The electrical device includes a first electrical contact structure. The flexible mounting rack system further includes a circuit board arranged at the support rear surface of the support plate. The circuit board is provided with a plurality of electrical connection units, and each of the electrical connection units includes a second electrical contact structure and a circuit connected to the second electrical contact structure. The support plate is provided with an electrical connection through-hole passing through the support rear surface and the support front surface at each of the mounting stations. The second electrical contact structure is aligned with the electrical connection through-hole. Upon the electrical device being mounted at one of the mounting stations, the device-side connection structure is connected to the support-side connection structure, and the first electrical contact structure is in contact with and electrically connected to the second electrical contact structure through the electrical connection through-hole.

Furthermore, in some embodiments, the second electrical contact structure includes X pins, and the first electrical contact structure includes Y contact points, where Y ≤ X. Upon the electrical device being mounted, each of the contact points is respectively in contact with a corresponding one of the pins. In other embodiments, the second electrical contact structure includes X contact points, and the first electrical contact structure includes Y pins, where Y ≤ X. Upon the electrical device being mounted, each of the pins is respectively in contact with a corresponding one of the contact points.

Furthermore, the pins are spring-loaded pins, and the pins are in an elastically compressed state upon being in contact with the contact points.

Furthermore, the electrical device includes a first electrical connection base, and the first electrical contact structure is disposed on the first electrical connection base. Each of the electrical connection units further includes a second electrical connection base, and the second electrical contact structure is disposed on the second electrical connection base.

Furthermore, the circuit board is an integrated circuit board.

Furthermore, the circuit board is further provided with a terminal block, and the circuit of each of the electrical connection units is connected to the terminal block.

Furthermore, the support-side connection structure of the support plate includes multiple connection slots, and the device-side connection structure is provided with a snap-fit structure configured to be received in one or more of the connection slots.

Furthermore, the flexible mounting rack system further includes multiple cover plates. The cover plates are mounted on the support front surface of the support plate and covers the support-side connection structure and the electrical connection through-hole.

Furthermore, a rear surface of each of the cover plates facing the support front surface is provided with a third electrical contact structure, and a front surface of each of the cover plates is provided with a display screen. Upon each of the cover plates being mounted on the support front surface, the third electrical contact structure is electrically connected with the second electrical contact structure.

Furthermore, the rear surface of each of the cover plates is provided with a cover-plate connection structure configured to be detachably connected to the support-side connection structure.

The flexible mounting rack system of the present invention has the following advantageous effects.

1. The circuit board is provided on a rear side of the support plate, with multiple electrical connection units arranged corresponding to the mounting stations. When an electrical device is installed at one of the mounting stations, the first electrical contact structure of the electrical device is in contact with the second electrical contact structure on the circuit board to establish electrical connection. Therefore, when a circuit of the electrical connection unit is energized, the electrical device is powered. This design simplifies electrical connection during installation of the electrical device, thereby facilitating mounting, removal, and positional adjustment of the electrical device on the support plate without requiring adjustment of wiring, while also improving overall neatness and appearance.

2. The flexible mounting rack system is suitable for use in various environments, including exhibition halls, shopping malls, supermarkets, and retail stores, and is adaptable to different types of electrical devices.

3. By providing cover plates, portions of the support plate not occupied by the electrical device may be covered, thereby improving appearance and providing protection. The cover plates may further be implemented as display panels with display functionality, thereby facilitating installation and electrical connection on the support plate.

### BRIEF DESCRIPTION OF DRAWINGS

FIG. 1 is a first schematic structural diagram of a flexible mounting rack system according to the present invention.
FIG. 2 is a second schematic structural diagram of a flexible mounting rack system according to the present invention.
FIG. 3 is a front view of FIG. 1.
FIG. 4 is a side view of FIG. 1.
FIG. 5 is an enlarged view of portion A of FIG. 4.
FIG. 6 is a schematic structural view of a circuit board according to the present invention.
FIG. 7 is a schematic structural diagram of an electrical device according to the present invention.

### Reference numerals

- 1: electrical device
- 11: support bracket
- 12: electrical component
- 13: snap-fit block
- 14: first electrical connection base
- 15: contact point
- 2: support plate
- 21: support front surface
- 22: support rear surface
- 23: electrical connection through-hole
- 24: connection slot
- 3: circuit board
- 31: second electrical connection base
- 32: pin
- 33: terminal block
- 34: ribbon cable
- 4: connection post
- 5: cover plate
- 51: cover-plate connection structure
- 52: display screen
- 53: third electrical contact structure

### DETAILED DESCRIPTION

The specific embodiments are described below to illustrate the implementation of the present invention, and people skilled in the art can easily understand other advantages and effects of the present invention from the content disclosed in this specification.

It should be noted that the structures, proportions, sizes, etc. shown in the accompanying drawings are only intended to complement the content disclosed in the specification for the understanding and reading by those familiar with the technology, and they are not conditions to limit the implementation of the present invention. Any modification of the structure, change in proportion, or adjustment of size, as long as they do not compromise the effectiveness and purpose of this invention, should still be considered within the scope of the technical contents disclosed in the present invention. In addition, terms such as "upper", "lower", "left", "right", "middle" and the like used in this specification are for ease of description only and are not intended to limit the scope of the present invention. Any changes or adjustments to the relative relationships of the components, without substantially altering the technical content, should also be considered within the scope of implementations of the present invention.

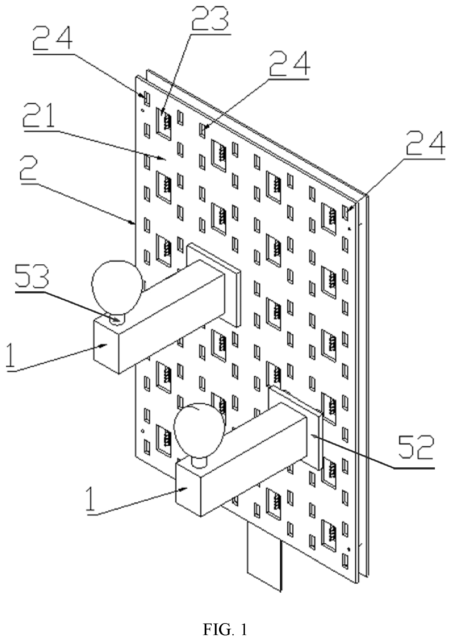

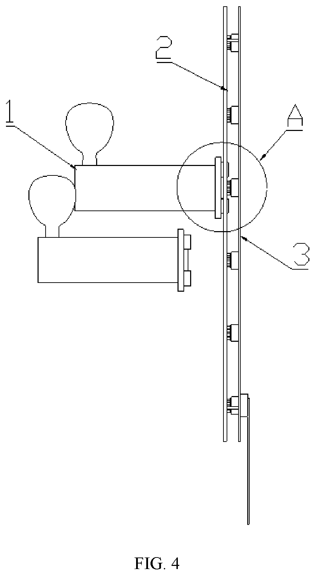

As shown in FIGs. 1 to 7, the present invention provides a flexible mounting rack system with a circuit board for providing an electrical connection, which can accommodate an electrical device 1 requiring a power supply. The electrical device 1 includes a device-side connection structure. The flexible mounting rack system includes a support plate 2. Opposite sides of the support plate 2 are respectively defined as a support front surface 21 and a support rear surface 22. The electrical device 1 is mounted on the support front surface 21, which includes multiple mounting stations for the electrical device 1. Each of the mounting stations is provided with a support-side connection structure which can be detachably connected with the device-side connection structure. In the present invention, the electrical device 1 includes a first electrical contact structure. The flexible mounting rack system further includes a circuit board 3, which is disposed on the support rear surface 22 of the support plate 2 and is provided with multiple electrical connection units. Preferably, the number of electrical connection units is equal to the number of mounting stations, and the electrical connection units are in one-to-one correspondence with the mounting stations. Each of the electrical connection units includes a second electrical contact structure and a circuit (not shown in the drawings) connected to the second electrical contact structure. The support plate 2 is provided with an electrical connection through-hole 23 passing through the support rear surface 22 and the support front surface 21 at each of the mounting stations. The second electrical contact structure is aligned with the electrical connection through-hole 23. Upon the electrical device 1 being mounted at one of the mounting stations, the device-side connection structure is connected to the support-side connection structure, ensuring stable installation. The first electrical contact structure is in contact with and electrically connected to the second electrical contact structure through the electrical connection through-hole 23.

The flexible mounting rack system of the present invention can be used to install and display various electrical devices 1. Before use, the support plate 2 and the circuit board 3 are assembled, with each mounting station corresponding to one electrical connection unit on the circuit board 3. During use, according to the installation requirements, the electrical device 1 is mounted at one of the mounting stations on the support front surface 21 of the support plate 2. The device-side connection structure is connected to the support-side connection structure at the one of the mounting stations to securely install the electrical device 1, and the first electrical contact structure of the electrical device 1 remains in contact with the second electrical contact structure of the corresponding electrical connection unit through the electrical connection through-hole 23, establishing an electrical connection. When a power input side of the circuit of the corresponding electrical connection unit is connected to a power supply, the electrical device 1 is supplied with power. The electrical device (1) can be easily mounted and removed. When positional adjustment is required, the electrical device (1) can be detached from one mounting station and reinstalled at another, with the electrical connection being automatically established upon installation. Accordingly, frequent wiring adjustments are avoided compared with conventional designs. Therefore, the flexible mounting rack system of the present invention addresses the problem of complex electrical connections during the installation of the electrical device 1 on the support plate 2. It facilitates the placement, removal, and repositioning of the electrical device 1 on the support plate 2, thereby simplifying installation and removal operations and improving overall appearance, neatness, and safety.

Referring to FIGs. 1-7, the present invention will be further described below with reference to a specific embodiment.

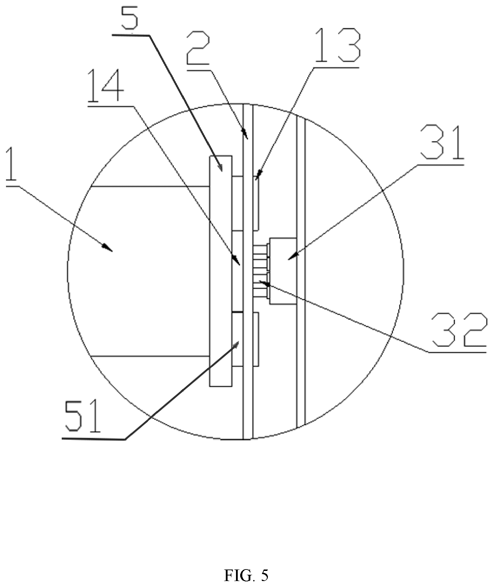

In this embodiment, as shown in FIGs. 5 to 7, preferably, the second electrical contact structure includes X pins 32, and the first electrical contact structure includes Y contact points 15, where Y ≤ X. When the electrical device 1 is installed, each contact point 15 is in contact with a corresponding pin 32, thereby establishing an electrical connection. When different electrical devices 1 are installed, the number of the contact points 15 may vary. Preferably, the number of pins 32 is relatively large so as to accommodate different usage requirements. Furthermore, the pins 32 are preferably spring-loaded pins, which exhibit good elasticity and flexibility. Upon contacting the contact points 15, the pins 32 are elastically compressed to generate contact pressure with the contact points 15, thereby ensuring a reliable electrical connection. In other embodiments, positions of the pins 32 and the contact points 15 may be interchanged; that is, the pins 32 can be disposed on the electrical device 1, and the contact points 15 can be disposed on the circuit board 3. Additionally, the first and second electrical contact structures may be implemented in other suitable configurations.

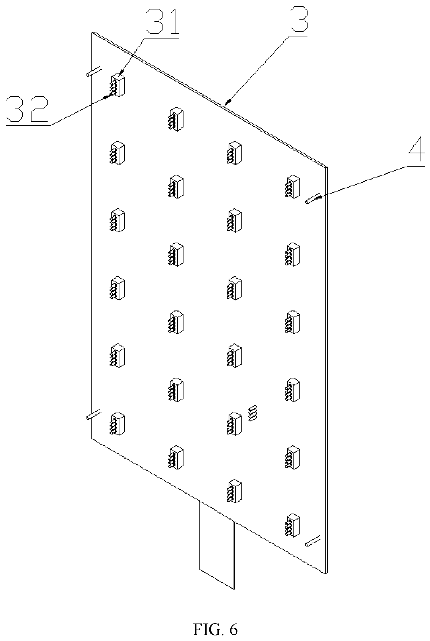

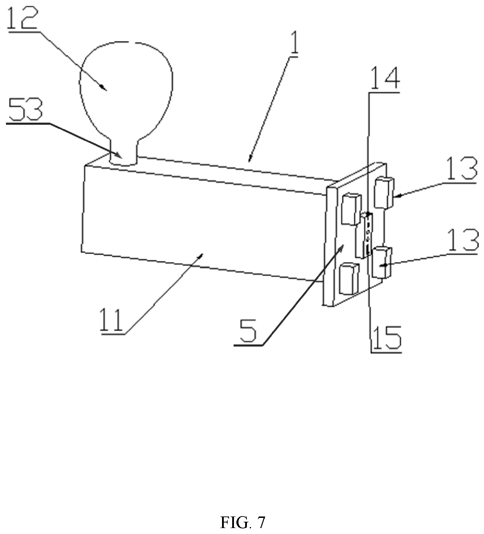

In this embodiment, with reference to FIG. 7, the electrical device 1 includes a support bracket 11 and an electrical component 12. The support bracket 11 may have various structural configurations, and the electrical component 12 is disposed on the support bracket 11. The support bracket 11 is provided with the device-side connection structure, and a first electrical connection base 14 is provided at the device-side connection structure. The contact points 15 of the first electrical contact structure are disposed on the first electrical connection base 14 and electrically connected to the electrical component 12. Therefore, when the contact points 15 are in contact with energized pins 32, the electrical component 12 is supplied with power. Referring to FIG. 6, each of the electrical connection units of the circuit board 3 includes a second electrical connection base 31. The second electrical contact structure is disposed on the second electrical connection base 31. The second electrical connection base 31 and the second electrical contact structure do not protrude beyond the electrical connection through-hole 23. When the electrical device 1 is installed, as shown in FIG. 5, the first electrical connection base 14 of the electrical device 1 extends into the electrical connection through-hole 23, and the contact points 15 are in contact with the pins 32. The first electrical connection base 14 and the second electrical connection base 31 provide structural support for the contact points 15 and the pins 32, thereby ensuring stable electrical contact and facilitating installation.

In this embodiment, with reference to FIGs. 1 and 6, as a preferred design, the circuit board 3 is an integrated circuit board, and the circuits of the electrical connection units are integrated on the circuit board 3. In other embodiments, the circuits may also be implemented using standard wires arranged on a substrate of the circuit board 3. The circuit board 3 is fixed to the support rear surface 22 of the support plate 2 via multiple connection posts 4 and is spaced from the support rear surface 22. By replacing the circuit board 3, different electrical connection requirements in various applications can be satisfied.

In this embodiment, with reference to FIGs. 1 and 6, as a preferred design, the circuit board 3 is further provided with a terminal block 33. The circuits of the electrical connection units are collectively connected to the terminal block 33, and the terminal block 33 is connected to an external power source or signal source via a ribbon cable 34, thereby facilitating wiring.

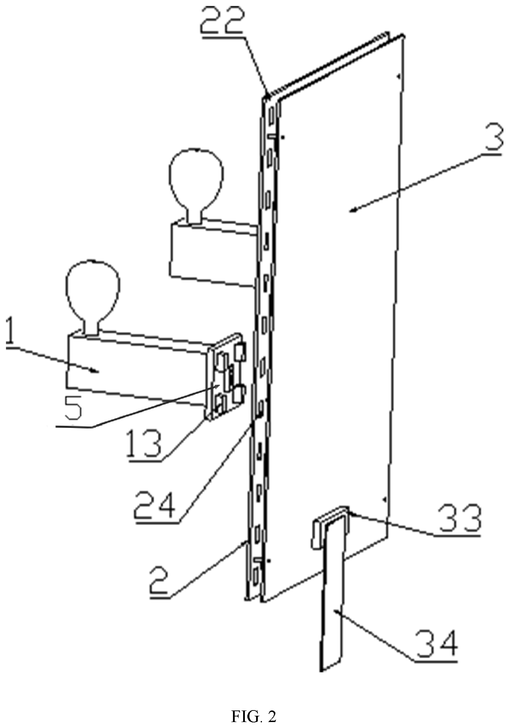

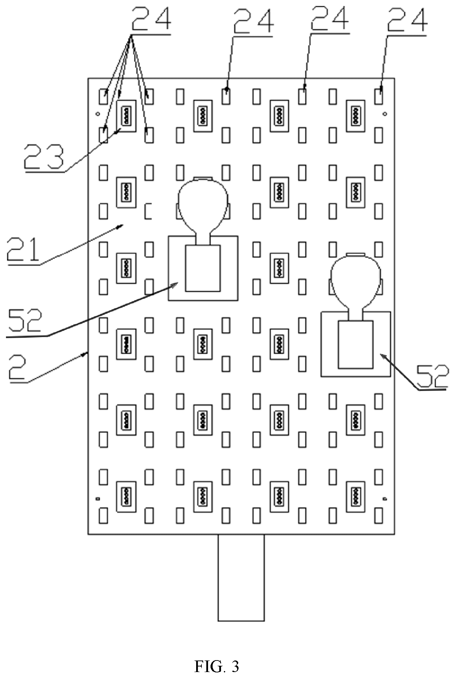

In this embodiment, with reference to FIGs. 1 and 3, as a preferred design, the support-side connection structure on the support plate 2 includes a plurality of connection slots 24, and the device-side connection structure is provided with a snap-fit structure which can engage with the connection slots 24. The number of connection slots 24 can be adjusted according to the specific requirements. Specifically, in this embodiment, the support-side connection structure includes four connection slots 24, and the electrical connection through-hole 23 is arranged between the four connection slots 24. The snap-fit structure can take various configurations. Specifically, the snap-fit structure may include four elastic snap-fit blocks 13, as shown in FIGs. 2 and 7. The four snap-fit blocks 13 are respectively received in the four connection slots 24 and are in close engagement with the four connection slots 24. The snap-fit structure may also have other suitable configurations, such as using four snap-fit hooks. For example, the snap-fit structure may include four snap-fit hooks, which are respectively received in the four connection slots 24 and latch onto the edges of the connection slots 24, thereby enabling stable installation and facilitating disassembly.

In this embodiment, with reference to FIGs. 1 and 3, the support plate 2 is a square plate having a certain thickness and structural strength. During use, the support plate 2 can be placed vertically, horizontally, or at an angle. When the support plate 2 is arranged in a vertical orientation, opposite square faces of the support plate 2 define the support front surface 21 and the support rear surface 22, respectively. In this embodiment, multiple support-side connection structures are arranged in a rectangular array on the support front surface 21, forming multiple rows and columns, thereby facilitating installation and positional adjustment of the electrical device 1. Additionally, the support plate 2 may also be cylindrical. An outer cylindrical surface of the support plate 2 defines the support front surface 21, and an inner cylindrical surface of the support plate 2 defines the support rear surface 22. The multiple support-side connection structures are arranged on the support front surface 21 in a rectangular array, and the support-side connection structures in each row are circumferentially arranged in an annular array around the outer cylindrical surface. In other embodiments, the support plate 2 may have other shapes.

In this embodiment, as a preferred design, the flexible mounting rack system further includes multiple cover plates 5. The cover plates 5 can be installed on the support front surface 21 of the support plate 2 and cover the support-side connection structure and the electrical connection through-hole 23. Specifically, each of the cover plates 5 is installed at a corresponding mounting station and covers the support-side connection structure and the electrical connection through-hole 23 at the corresponding mounting station. When the electrical device 1 is not mounted, the corresponding cover plates 5 may be installed at all the mounting stations. The cover plates 5 are arranged adjacent to each other, with adjacent cover plates 5 being in close contact or separated by a small gap therebetween, thereby forming a large-area composite panel covering the support front surface 21 and concealing the support-side connection structures and the electrical connection through-holes 23 on the support plate 2. This prevents exposure that may affect appearance, while also protecting the second electrical contact structure. Rear surfaces of the cover plates 5 face the support front surface 21, and front surfaces of the cover plates 5 may be provided with different patterns and colors. The front surfaces of the cover plates 5 may be arranged to form an integrated pattern, thereby improving overall appearance. When the electrical device 1 is to be installed, the cover plate 5 at the corresponding mounting station is removed, and the electrical device 1 is installed at the corresponding mounting station. The cover plates 5 at positions where no electrical device 1 is installed remain installed, thereby maintaining the overall appearance of the support plate 2 during use. The cover plates 5 also provide protection by preventing debris from entering through the electrical connection through-hole 23 and the connection slots 24, thereby protecting the circuit board 3.

In this embodiment, the cover plates 5 can be installed into the connection slots 24 of the support plate 2 by means of snap-fitting. Specifically, the rear surface of each of the cover plates 5 is provided with a cover-plate connection structure 51 corresponding to the snap-fit structure of the device-side connection structure, thereby facilitating the installation and removal of the cover plates 5. Alternatively, the cover plates 5 may be fixed to the support plate 2 by magnetic attraction. For example, the rear surface of each cover plate 5 may be provided with a magnetic block, and the support plate 2 may be made of a ferromagnetic material or may include a magnetic block, such that the cover plates 5 are magnetically attracted and fixed to the support front surface 21 of the support plate 2.

In this embodiment, the cover plates 5 are display panels with display functionality. The rear surface of each cover plate 5 is provided with a third electrical contact structure 53, and the front surface of each cover plate 5 is provided with a display screen 52. Upon being mounted on the support front surface 21, the third electrical contact structure 53 is in contact with the second electrical contact structure, thereby establishing an electrical connection. Specifically, the cover plates 5 may be LCD tiled display panels. Each cover plate 5 is independently connected for wiring and display, and the multiple cover plates 5 collectively form a large display screen 52. The third electrical contact structures 53 on the rear surfaces of the cover plates 5 may correspond to the first electrical contact structure in the electrical device 1 and operate on a similar principle.

The flexible mounting rack system of the present invention has the following advantageous effects.
1. The circuit board 3 is provided on the rear side of the support plate 2, with multiple electrical connection units arranged corresponding to the mounting stations. When an electrical device 1 is installed at one of the mounting stations, the first electrical contact structure of the electrical device 1 is in contact with the second electrical contact structure on the circuit board 3 to establish an electrical connection. Therefore, when a circuit of the electrical connection unit is energized, the electrical device 1 is powered. This design simplifies electrical connection during installation of the electrical device 1, thereby facilitating mounting, removal, and positional adjustment of the electrical device 1 on the support plate 2 without requiring adjustment of wiring, while also improving overall neatness and appearance.
2. The flexible mounting rack system is suitable for a variety of settings, including exhibitions, shopping malls, supermarkets, and general stores, and can be used with a variety of electrical devices 1, providing a wide range of applications.
3. By providing cover plates 5, areas where the electrical device 1 is not installed can be covered, achieving both aesthetic and protective functions. Additionally, the cover plates 5 may be implemented as display panels with display functionality, facilitating installation and wiring on the support plate 2. In summary, the present invention effectively overcomes various drawbacks of the prior art and possesses significant industrial applicability.

The embodiments described above serve merely as illustrative examples of the principles and effects of the present invention, and are not intended to serve as limitations on the present invention. Persons skilled in the art may modify or alter these embodiments without departing from the spirit and scope of the present invention. Accordingly, all equivalent modifications or alterations accomplished by persons having ordinary knowledge in the art without departing from the spirit and technical ideas disclosed herein shall still be covered by the claims of the present invention.

## Claims

1. A flexible mounting rack system with a circuit board for providing electrical connection, configured to accommodate an electrical device (1) requiring power supply, wherein the electrical device (1) comprises a device-side connection structure, wherein the flexible mounting rack system comprises a support plate (2), and opposite side surfaces of the support plate (2) are respectively defined as a support front surface (21) and a support rear surface (22), wherein the electrical device (1) is mounted on the support front surface (21), wherein the support front surface (21) is provided with a plurality of mounting stations for mounting the electrical device (1), and each of the mounting stations is provided with a support-side connection structure configured to detachably connect with the device-side connection structure, wherein the electrical device (1) comprises a first electrical contact structure, wherein the flexible mounting rack system further comprises a circuit board (3) arranged at the support rear surface (22) of the support plate (2), wherein the circuit board (3) is provided with a plurality of electrical connection units, and each of the electrical connection units comprises a second electrical contact structure and a circuit connected to the second electrical contact structure, wherein the support plate (2) is provided with an electrical connection through-hole (23) passing through the support rear surface (22) and the support front surface (21) at each of the mounting stations, wherein the second electrical contact structure is aligned with the electrical connection through-hole (23), wherein upon the electrical device (1) being mounted at one of the mounting stations, the device-side connection structure is connected to the support-side connection structure, and the first electrical contact structure is in contact with and electrically connected to the second electrical contact structure through the electrical connection through-hole (23).

2. The system according to claim 1, wherein the second electrical contact structure comprises X pins (32), and the first electrical contact structure comprises Y contact points (15), wherein Y ≤ X, wherein upon the electrical device (1) being mounted, each of the contact points (15) is respectively in contact with a corresponding one of the pins (32); or
wherein the second electrical contact structure comprises X contact points (15), and the first electrical contact structure comprises Y pins (32), wherein Y ≤ X, wherein upon the electrical device (1) being mounted, each of the pins (32) is respectively in contact with a corresponding one of the contact points (15).

3. The system according to claim 2, wherein the pins (32) are spring-loaded pins, and the pins (32) are in an elastically compressed state upon contacting the contact points (15).

4. The system according to claim 1 or 2, wherein the electrical device (1) comprises a first electrical connection base (14), and the first electrical contact structure is disposed on the first electrical connection base (14), wherein each of the electrical connection units further comprises a second electrical connection base (31), and the second electrical contact structure is disposed on the second electrical connection base (31).

5. The system according to claim 1, wherein the circuit board (3) is an integrated circuit board.

6. The system according to claim 1 or 5, wherein the circuit board (3) is further provided with a terminal block (33), and the circuit of each of the electrical connection units is connected to the terminal block (33).

7. The system according to claim 1, wherein the support-side connection structure of the support plate (2) comprises a plurality of connection slots (24), and the device-side connection structure is provided with a snap-fit structure configured to be received in one or more of the connection slots (24).

8. The system according to claim 1, further comprising a plurality of cover plates (5), wherein the plurality of cover plates (5) is mounted on the support front surface (21) of the support plate (2) and covers the support-side connection structure and the electrical connection through-hole (23).

9. The system according to claim 8, wherein a rear surface of each of the cover plates (5) facing the support front surface (21) is provided with a third electrical contact structure (53), and a front surface of each of the cover plates (5) is provided with a display screen (52), wherein, upon each of the cover plates (5) being mounted on the support front surface (21), the third electrical contact structure (53) is electrically connected with the second electrical contact structure.

10. The system according to claim 8 or 9, wherein a rear surface of each of the cover plates (5) is provided with a cover-plate connection structure (51) configured to be detachably connected to the support-side connection structure.
